# EUROPEAN PATENT SPECIFICATION

(11) **EP 3 691 433 B1**
(45) Date of publication and mention of the grant of the patent: **26.01.2022**
(21) Application number: 18883276.0
(22) Date of filing: 13.11.2018
(51) Int. Cl.: H05K 13/04, H01L 21/52, H05K 13/08

(54) **ELECTRONIC COMPONENT MOUNTING DEVICE**
MONTAGEVORRICHTUNG FÜR ELEKTRONISCHE KOMPONENTE
DISPOSITIF DE MONTAGE DE COMPOSANT ÉLECTRONIQUE

(30) Priority: 29.11.2017 JP 2017229650
(43) Date of publication of application: 05.08.2020
(73) Proprietor: Asahi Engineering K.K., Kurume-shi, Fukuoka 839-0809 (JP)
(72) Inventor: ISHII, Masaaki, Kurume-shi Fukuoka 839-0809 (JP)
(74) Representative: Prüfer & Partner mbB Patentanwälte · Rechtsanwälte
(86) International application number: PCT/JP2018/041886
(87) International publication number: WO 2019/107137

(56) References cited:
- WO-A1-2010/110445
- WO-A1-2016/031806
- JP-A- H09 172 294
- JP-A- 2007 287 944
- JP-A- 2012 126 074
- JP-A- 2014 225 619
- US-A- 5 523 642
- US-A1- 2008 230 589

## Description

### Technical Field

The present invention relates to an electronic component mounting apparatus for mounting an electronic component on a substrate.

### Background Art

Many electronic devices, measuring devices, transportation devices, precision instruments, and so forth have many electronic components such as semiconductor integrated circuits. Processors, image processing circuits, speech processing circuits, various sensors, and so forth have been highly integrated, and many functions have been integrated in an electronic component. This electronic component is necessary for these devices.

This electronic component is required to be mounted on a substrate such as a lead frame, a flexible frame, an electronic substrate, a meatal base, or a heat sink.

When the substrate itself is incorporated in an electronic device or the like, the electronic component is mounted on this incorporated substrate. Alternatively, the electronic component may be mounted on a substrate required in a manufacturing process. This is because the electronic component, when required in an electronic device or the like, is required to be mounted via the substrate.

In this manner, it is often the case that the electronic component such as a semiconductor integrated circuit is mounted on a substrate such as a lead frame, an electronic substrate, a metal base, or a heat sink.

Here, when the electronic component is mounted on the substrate, there is a method of applying an adhesive between the substrate and the electronic component and applying pressure and heat to perform mounting by the adhesive. A mounting apparatus with this method may be referred to as a sintering apparatus. Here, the substrate is of a single layer or multilayer, is configured of one sheet or a plurality of laminated sheets, or the like.

In the substrate, a mounting position is set, which is a position where the electronic component is to be mounted. At this mounting position, the adhesive is applied. Furthermore, the electronic component is set at the mounting position so that the electronic component makes contact with this adhesive. In this state, pressure and heat are applied to the electronic component.

With this application of pressure and heat, adhesion of the electronic component to the substrate by the adhesive is achieved. As a result, an adhesive layer occurs between the substrate and the electronic component. Via this adhesive layer, the electronic component is mounted onto the substrate.

In this manner, the electronic component is mounted on the substrate to achieve storage of the electronic component into the electronic device or the like or for the next manufacturing process using the electronic component. Since mounting is performed with pressure and heat via the adhesive, this is suitable to mount a large amount of electronic components.

A technique regarding this electronic component mounting apparatus called a sintering apparatus has been suggested (for example, JP 2016-507164 A (PTL 1).

US 5 523 642 A discloses a component mounting apparatus according to preamble of claim 1.

### Summary of Invention

### Technical Problem

In PTL 1, a semiconductor die enclosing method or a semiconductor die carrier mounting method includes: a step of providing a first tool unit for holding a plurality of semiconductor dies and a step of providing the semiconductor dies on the first tool unit; a step of providing a second tool unit, one of the first tool unit and the second tool unit having a plurality of movable insertion members allowing pressure to be applied onto a surface area of the semiconductor dies by each of the movable insertion members; and a step of defining a space between the first tool unit and the second tool unit and combining the first tool unit and the second tool unit so that semiconductor products are arranged in the space. The movable insertion members apply pressure onto the surface area of the semiconductor dies. The pressure applied by the movable insertion members is monitored and adjusted. Next, the first tool unit and the second tool unit are separated, and the processed semiconductor dies are removed. Such a semiconductor die mounting apparatus is disclosed.

PTL 1 discloses a technique of simultaneously mounting the plurality of semiconductor dies on a substrate by using resin. Here, PTL 1 has a structure in which each semiconductor die and the substrate are interposed by a movable member and a fixed member. Based on this structure, the movable member capable of vertically moving applies pressure to the semiconductor die, and the fixed member receives this. As a result, mounting by an adhesive is achieved.

However, in the technique of PTL 1, the movable member applies pressure to the semiconductor die. That is, the moving movable member applies pressure to the semiconductor die and the substrate received by the fixed member, and thus there is a fear of occurrence of damages on the semiconductor die and the substrate. This is because applying pressure too much can cause damages. Alternatively, even if pressure is not applied too much, the moving movable member directly applies pressure to the semiconductor die and the substrate (the movable member pushes them directly or via a film or the like), and this operation can damage the semiconductor die and the substrate.

Conversely, if pressure is weakened so as not to cause damages, there is a problem in which mounting by resin is insufficient. To prevent either case from occurring, it is required to find an optimum value of pressure to be applied in accordance with the type and others of the semiconductor die and the substrate. There is a problem in which finding this optimum value increases a load in the manufacturing process.

Also, if the pressure applied by the movable member is unsuitable, an adhesive layer between the semiconductor die and the substrate may be left as having a large thickness. When the adhesive layer between the semiconductor die and the substrate is thick, if the semiconductor dies are high-frequency semiconductors or power semiconductors, this leads to problems such as one in which their performance is not sufficiently induced.

Thus, if the applied pressure is unsuitable, mounting accuracy becomes insufficient, also leading to a problem of causing insufficient performance of the mounted semiconductor dies (electronic components). Or, there is also a problem in which mounting becomes insufficient, which may lead to a malfunction after mounting.

Furthermore, it is required to mount a plurality of electronic components on a substrate, and it is required to mount the plurality of electronic components all at once. This is for making the manufacturing process efficient and reducing cost. Here, in the multilayer of the substrate, the adhesive, and the electronic components, the thickness of each of the plurality of electronic components may be uneven.

When the thickness is uneven, if application of pressure by the movable member corresponding to each of the electronic components does not support unevenness, there is a problem in which variations in mounting occur in each of the plurality of electronic components. Variations in mounting lead to variations in performance and variations in durability, which are not preferable. In PTL 1, there is a problem in which the movable member directly applies pressure to the semiconductor die and thus it is difficult to absorb these variations.

As described above, conventional techniques including PTL 1 have problems such as damages to the electronic components and the substrate and insufficiency of mounting accuracy.

The present invention has an object of providing an electronic component mounting apparatus less prone to cause damages to electronic components and a substrate and capable of mounting the electronic components on the substrate with high mounting accuracy.

### Solution to Problems

The above-described problem is solved by an electronic component mounting apparatus according to claim 1.

### Advantageous Effects of Invention

The electronic component mounting apparatus of the present invention is configured such that while the fixed member applies pressure, the movable member lets overpressure escape, thereby allowing prevention of application of excessive pressure to the electronic component and the substrate. Here, pressure optimum value control by pressure application by the fixed member is also reduced, and thus the load on the apparatus is reduced.

Furthermore, since it is also possible to prevent pressure from being too small, it is also possible to prevent insufficient performance of the electronic component after mounting from occurring because the adhesive layer becomes too thick.

Still further, even if a plurality of electronic components are mounted all at once, an excess of pressure applied from the fixed member to the movable member is let escape by the movable member. Thus, pressure control corresponding to individual electronic components is also not required. As a result, apparatus control is simplified, and the load and cost in the manufacturing process can be reduced.

### Brief Description of Drawings

Figure 1 is a front view of a substrate with electronic components mounted thereon.
Figure 2 is a side view of the substrate with the electronic components mounted thereon.
Figure 3 is a block diagram of an electronic component mounting apparatus in a first embodiment of the present invention.
Figure 4 is a block diagram of the electronic component mounting apparatus in the first embodiment of the present invention.
Figure 5 is a block diagram of the electronic component mounting apparatus in the first embodiment of the present invention.
Figure 6 is a block diagram of the electronic component mounting apparatus in the first embodiment of the present invention.
Figure 7 is a block diagram of the electronic component mounting apparatus in the first embodiment of the present invention, depicting pressure application by a fixed member.
Figure 8 is a block diagram of an electronic component mounting apparatus in a second embodiment of the present invention.
Figure 9 is a block diagram of the electronic component mounting apparatus in the second embodiment of the present invention.

### Description of Embodiments

An electronic component mounting apparatus according to claim 1 is referred to.

This structure allows the electronic component and so forth to be prevented from being damaged by excessive pressure at the time of mounting by adhesion or the like by applying pressure.

In the electronic component mounting apparatus the movement control unit allows the first form and the second form to approach each other to cause the fixed member to make contact with the electronic component or the substrate, and
the contact allows the fixed member to apply pressure to at least one of the electronic component and the substrate.

This structure allows the fixed member to apply pressure for mounting.

In the electronic component mounting apparatus with pressure applied by the fixed member to at least one of the electronic component and the electronic substrate and with the overpressure let escape by the movable member, the electronic component is mounted on the substrate.

This structure allows mounting by optimum pressure for mounting. Also, since overpressure is absent, damage of the electronic component and so forth can be prevented.

In the electronic component mounting apparatus the fixed member pushes the electronic component or the substrate to allow pressure to be applied to at least one of the electronic component and the substrate.

This structure allows pressure application by pressing.

In the electronic component mounting apparatus the second form has, preferably, a single or a plurality of insertion holes at a position corresponding to the fixed member, and the single or the plurality of movable members are inserted into the insertion holes to become changeable in position with respect to the second form.

The structure allows the movable member to let overpressure escape by a positional change.

In the electronic component mounting apparatus the movable member optionally changes the position in the insertion hole by pressure from the fixed member received via the electronic component and the substrate.

The structure allows the movable member to let overpressure escape.

In the electronic component mounting apparatus, preferably the movable member changes the position inside the insertion hole to let the overpressure escape.

This structure allows the movable member to let overpressure escape.

In the electronic component mounting apparatus, desirably the movable member is capable of adjusting an amount of the overpressure to be let escape with an amount of positional change inside the insertion hole.

This structure allows the movable member to absorb a difference in overpressure by a movable amount.

In the electronic component mounting apparatus the fixed member, the insertion hole, and the movable member each preferably correspond to a number of the single or the plurality of electronic components and positions thereof to be set to the setting member.

This structure allows the electronic component to be mounted.

In the electronic component mounting apparatus a sheet is optionally set between the fixed member and the electronic component.

This structure allows protection at the time of pressure application to the electronic component.

In the electronic component mounting apparatus an intermediate form is further optionally provided between the first form and the setting member, the intermediate form for holding an outer periphery of the electronic component, wherein
the intermediate form is capable of maintaining a state of holding the electronic component when the sheet is peeled off.

This structure allows the electronic component to be prevented from being pulled at the time of peeling off the sheet.

In the electronic component mounting apparatus , optionally the plurality of movable members are each capable of individually achieving its movable state.

This structure allows the plurality of electronic components to be mounted so as to optimally address their respective variabilities.

In the electronic component mounting , optionally the plurality of movable members are each capable of achieving the movable state with at least one of fluid pressure, elastic pressure, and motor driving.

With this structure, movability of the movable member is suitable for letting overpressure escape.

In the electronic component mounting apparatus according to the present invention, a pressure detecting unit is further provided which detects pressure applied to at least one of the electronic component and the substrate, wherein
the movable member is capable of changing the movable state based on the pressure.

This structure allows overpressure to be grasped from the pressure being actually applied by the fixed member to allow the movable member to let this overpressure escape. As a result, application of pressure with reality can be achieved.

In the electronic component mounting apparatus a movable member control unit is further optionally provided which controls at least one of a movable amount and a movable speed of the plurality of movable members, wherein
the movable member control unit is capable of controlling at least one of the movable amount, a movable time, and the movable speed of each of the plurality of movable members based on a movable control instruction table stored in advance.

This structure allows overpressure with reality to escape based on an actual pressure by the fixed member and a correlation between the pressure and the overpressure.

In the following, embodiments of the present invention are described with reference to the drawings.

### (Mounting of Electronic Components onto Electronic Substrate)

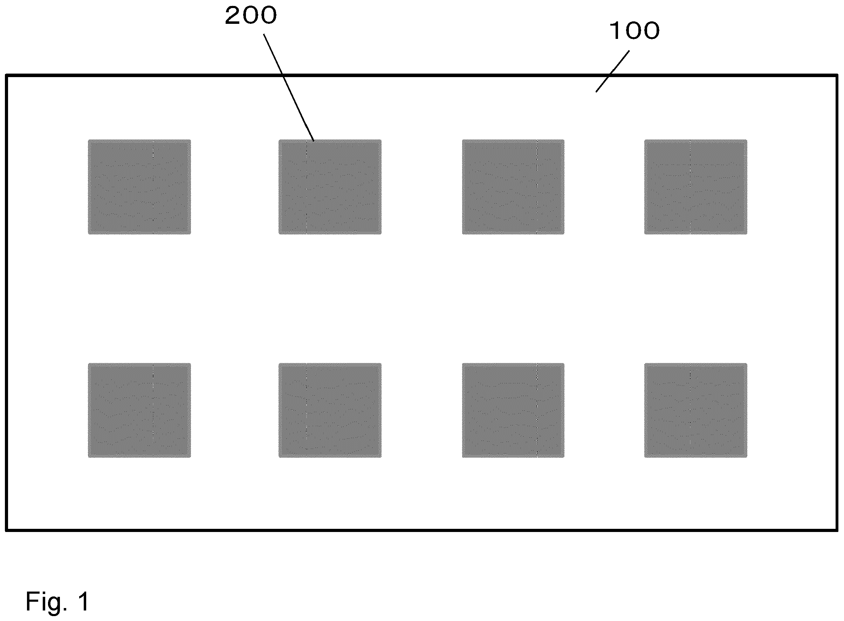

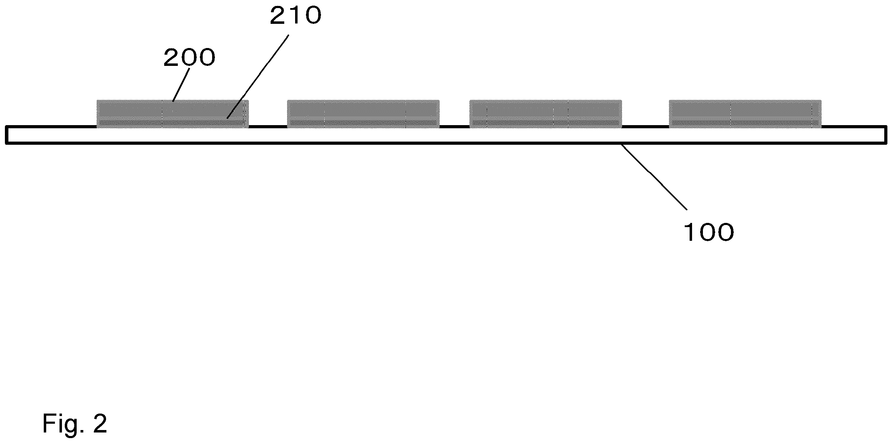

Mounting of an electronic component onto a substrate in the present invention described. Figure 1 is a front view of the substrate with electronic components mounted thereon. Figure 2 is a side view of the substrate with the electronic components mounted thereon. A substrate 100 is a lead frame, a metal base, a heat sink, an electronic substrate, or the like, and includes a flexible substrate, a tape substrate, a sheet substrate, and so forth. Also, the substrate has various structures such as a single layer and a multilayer.

Figure 1 depicts a state when the substrate 100 is viewed from above. On the substrate 100, a single or a plurality of electronic components 200 are mounted. In Figure 1, the plurality of electronic components 200 are mounted and, in this state as being unchanged, the substrate 100 may be stored in an electronic device or may be divided for each electronic component 200 for use.

As depicted in Figure 2, the electronic components 200 are mounted on the substrate 100 via an adhesive layer 210. The adhesive layer 210 is an adhesive or the like and with a bonding function of the adhesive, the electronic components 200 are mounted on the substrate 100. Before mounting, the adhesive is applied or the like. To this, pressure for mounting is applied. After mounting, the adhesive layer 210 is formed.

The electronic component mounting apparatus of the present invention achieves mounting as depicted in Figure 1 and Figure 2.

### (First Embodiment

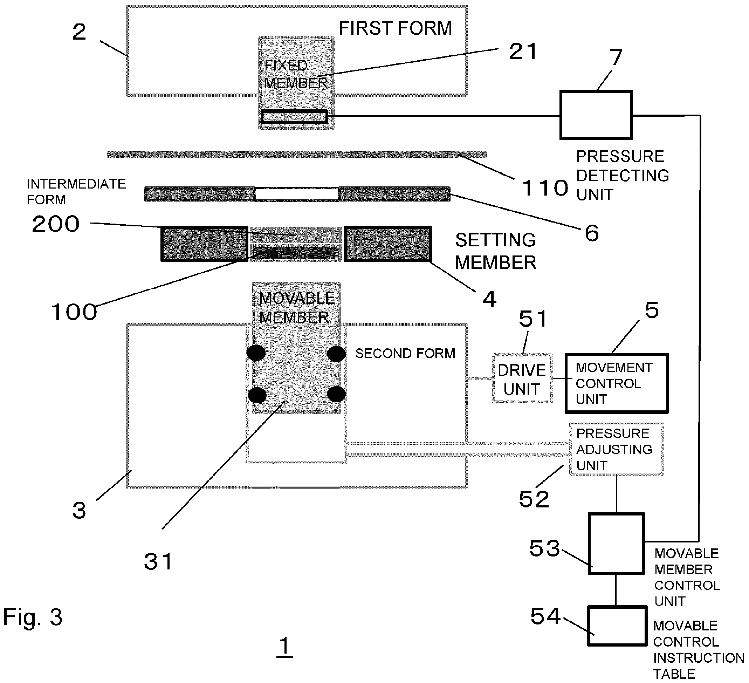

A first embdiment is described. Figure 3 is a block diagram of an electronic component mounting apparatus in a first embodiment of the present invention. An electronic component mounting apparatus 1 performs mounting of the electronic component 200 onto the substrate 100 described in Figure 1 and Figure 2.

The electronic component mounting apparatus 1 includes a first form 2, a second form 3, a setting member 4, and a movement control unit 5.

The first form 2 has a single or a plurality of fixed members 21. The fixed member 21 is in a state of being fixed to the first form 2, and a relative position with respect to the first form 2 is not changed. With respect to the first form 2, the fixed member 21 is positionally fixed. That is, the fixed member 21 moves its position together with the first form 2. Also, as will be described further below, with a space between the first form 2 and the second form 3 being narrowed, the fixed member 21 applies pressure to at least one of the electronic component 200 and the substrate 100 between the first form 2 and the second form 3.

The second form 3 is a member paired with the first form 2. While the first form 2 is depicted on an upper side and the second form 3 is depicted on a lower side in Figure 3, the vertical relation and the lateral relation are not limited to this. The second form 3 is paired with the first form 2. With relative positions in relation brought closer to each other, pressure application by the fixed member 21 to the electronic component 200 or the like is achieved.

The second form 3 has a single or a plurality of movable members 31. The movable member 31 can change its position with respect to the second form 3. That is, when the second form 3 comes closer to the first form 2, the movable member 31 can change its position with respect to the second form 3 depending on a state of contact with the electronic component 200 or the like.

As depicted in Figure 3, the movable member 31 is in a state of being inserted into a recessed part provided to the second form 3, and, by moving inside this recessed part, can move a positional change.

The setting member 4 sets the electronic component 200 and the substrate 100 between the first form 2 and the second form 3. As depicted in Figure 3, the setting member 4 sets to interpose the electronic component 200 and the substrate 100. The electronic component 200 is set at a position where it is to be mounted on the substrate 100. Alternatively, the electronic component 200 and the substrate 100 are positioned and positionally fixed via an adhesive. One in this state is placed on the setting member 4 and is set between the first form 2 and the second form 3.

The setting member 4 sets the electronic component 200 at a position where it is to be mounted on the substrate 100 (alternatively, the electronic component 200 positionally fixed already to the substrate 100 is set to the setting member 4), and it is set between the first form 2 and the second form 3. Being set, the electronic component 200 is mounted by pressure application by the first form 2 and the second form 3. Here, between the electronic component 200 and the substrate 100, an adhesive is applied or the like.

The movement control unit 5 controls an approach and separation of the first form 2 and the second form 3 in relation to this pressure application. The movement control unit 5 moves at least one of the first form 2 and the second form 3, thereby allowing control over an approach and separation of the first form 2 and the second form 3.

Here, the fixed member 21 and the movable member 31 each have a position relation corresponding to the position of the electronic component 200 to be set by the setting member 4. That is, with respect to the electronic component 200 to be set by the setting member 4, the fixed member 21 and the movable member 31 are at positions opposed to each other.

The movement control unit 5 causes the first form 2 and the second form 3 to approach each other. With this approach, the fixed member 21 applies pressure to at least one of the electronic component 200 and the substrate 100. With this application of pressure, the electronic component 200 is fixed to the substrate 100 by the action of the adhesive. At the time of pressure application, the movable member 31 can let overpressure, which is excessive in pressure to be applied by the fixed member 21, escape by movability.

With the movable member 31 letting overpressure escape, only the pressure required for mounting is applied to the electronic component 200 and the substrate 100, and excessive pressure is not applied. As a result, as in the conventional techniques, damages on the electronic component 200 and the substrate 100 and so forth do not occur.

Also, even when the plurality of electronic components 200 are simultaneously mounted, the movable member 31 can let excessive pressure escape so as to correspond to each overpressure that can be different for each electronic component 200. As a result, application of optimum pressure can be made for each of the plurality of electronic components 200 varied in height and mount surface. Without excessive pressure being applied, damages and so forth can be prevented. Furthermore, since the movable member 31 merely lets overpressure escape, pressure required for mounting is applied at each electronic component 200, and mounting can also be reliably performed.

The fixed member 21, the insertion hole 32, and the movable member 31 each correspond to the number of electronic components 200 and positions thereof to be set to the setting member 4.

### (Description of Operation)

Next, description of operation is performed.

### (Initial State: Figure 3)

Figure 3 described above depicts an initial state. In the initial state, the first form 2 and the second form 3 are separated. Also, between the first form 2 and the second form 3, the substrate 100 and the electronic component 200 are set by the setting member 4. Here, by the setting member 4, the electronic component 200 is set at a mounting position of the substrate 100 (alternatively, the substrate 100 is positionally fixed with an adhesive at the mounting position of the substrate 100, and the setting member 4 sets this between the first form 2 and the second form 3). Between the electronic component 200 and the substrate 100, an adhesive or the like is applied between the electronic component 200 and the substrate 100.

Also, as required, a sheet 110 may be set. The sheet 110 is set so as to be interposed between the fixed member 21 and the electronic component 200. As will be described further below, the fixed member 21 applies pressure to the electronic component 200 (if the position relation between the electronic component 200 and the substrate 100 is one acquired by turning Figure 3 upside down, the fixed member 21 applies pressure to the substrate 100). Here, this is because, with the sheet 110 being set, the fixed member 21 can be easily separated after pressure application.

The sheet 110 may be set between the movable member 31 and the substrate 100 or the electronic component 200.

As will be described from the next, the movement control unit 5 causes the first form 2 and the second form 3 to approach each other. This approach allows the fixed member 21 to directly or indirectly make contact with at least one of the electronic component 200 and the substrate 100. This contact allows the fixed member 21 to apply pressure to at least one of the electronic component 200 and the substrate 100.

This is because the fixed member 21 can apply pressure by pushing the electronic component 200 and the substrate 100.

With this application of pressure, the electronic component 200 is mounted on the substrate 100. Here, the movable member 31 can let overpressure escape, which is an excess in mounting in pressure from the fixed member 21. The movable member 31 can move along a pressure applying direction, and overpressure causes this movement.

This movement results in letting overpressure escape. When overpressure is let escape, only the pressure required for mounting is left, and mounting can be performed without causing damages or the like.

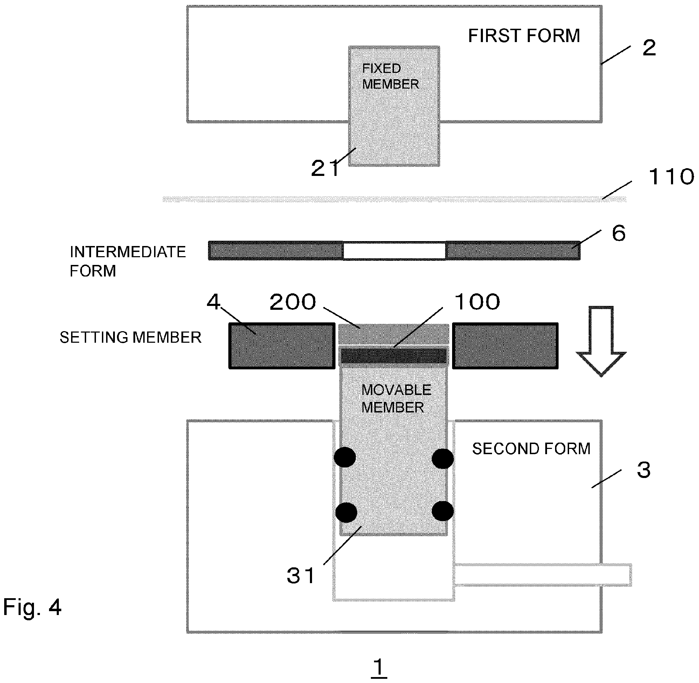

### (Movement of Setting Member: Figure 4)

Figure 4 is a block diagram of the electronic component mounting apparatus in the first embodiment of the present invention. The diagram is schematically depicted. While the diagram similarly includes components such as the movement control unit 5 depicted in Figure 3, these are omitted for viewability of the drawings. The operation by the movement control unit 5 is also performed in Figure 4.

As depicted in Figure 4, after the initial state, in the electronic component mounting apparatus 1, the setting member 4 descends to approach the second form 3. The setting member 4 sets the electronic component 200 and the substrate 100, and these set electronic component 200 and so forth approach the second form 3.

With the setting member 4 approaching the second form 3, the electronic component 200 and the substrate 100 set to the setting member 4 approach the movable member 31. When further approaching, it becomes in a state of being able to make contact with the movable member 31. Figure 4 depicts this state.

With this contactable state, at the time of pressure application from the fixed member 21, the movable member 31 can let overpressure escape.

Here, the electronic component mounting apparatus 1 includes a drive unit for operating each component, and this drive unit moves the setting member 4.

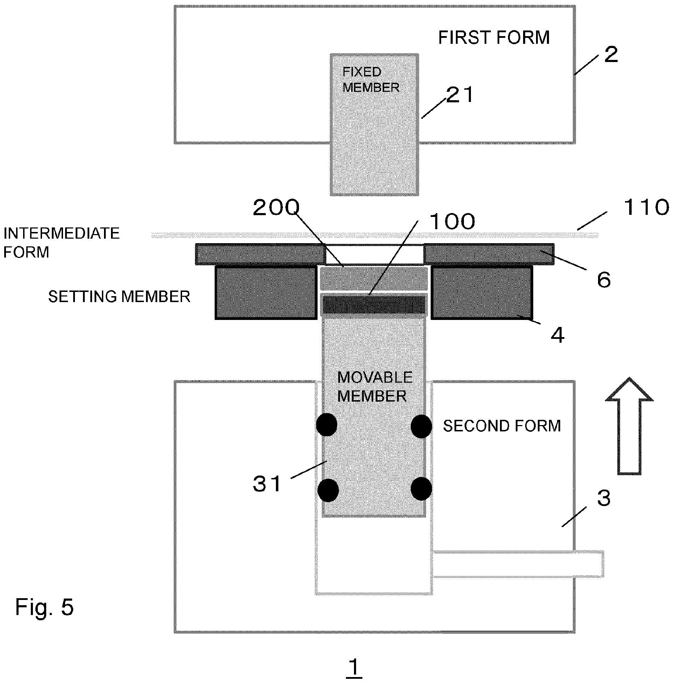

### (Movement of Intermediate Form and Sheet: Figure 5)

Figure 5 is a block diagram of the electronic component mounting apparatus in the first embodiment of the present invention. In the electronic component mounting apparatus 1, an intermediate form 6 and the sheet 110 are moved so as to approach the setting member 4. The intermediate form 6 and the sheet 110 may descend to approach the setting member 4, or the second form 3 may ascend to cause the setting member 4 to approach the intermediate form 6.

With the intermediate form 6 and the sheet 110 approaching the setting member 4, the intermediate form 6 approaches the electronic component 200. The same goes for the sheet 110. As described above, the sheet 110 is set between the fixed member 21 and the electronic component 200. The same goes for the intermediate form 6.

The intermediate form 6 is a member which holes the outer periphery of the electronic component 200 in the course of pressure application by the fixed member 21. When pressure application by the fixed member 21 is being performed, the electronic component 200 makes contact with the sheet 110. With the electronic component 200 making contact with the fixed member 21, the sheet 110 performs protection from the fixed member 21.

After application of pressure ends and the fixed member 21 is separated from the electronic component 200, the sheet 110 is peeled off from the electronic component 200. Here, the sheet 110 and the electronic component 200 receive pressure from the fixed member 21, the sheet 110 is as if being attached to the electronic component 200.

When the sheet 110 is peeled off in this state, there is a problem in which the electronic component 200 is pulled to the sheet 110. At the time of pressure application by the fixed member 21, the intermediate form 6 holds the electronic component 200 as surrounding the outer periphery thereof. By this holding, even if the sheet 110 is removed, it is possible to reduce the problem in which the electronic component 200 is pulled by the sheet 110.

In the stage of Figure 5, this intermediate form 6 and the sheet 110 approach so as to make contact with the electronic component 200. With this state provided, various problems in post treatment after mounting can be reduced.

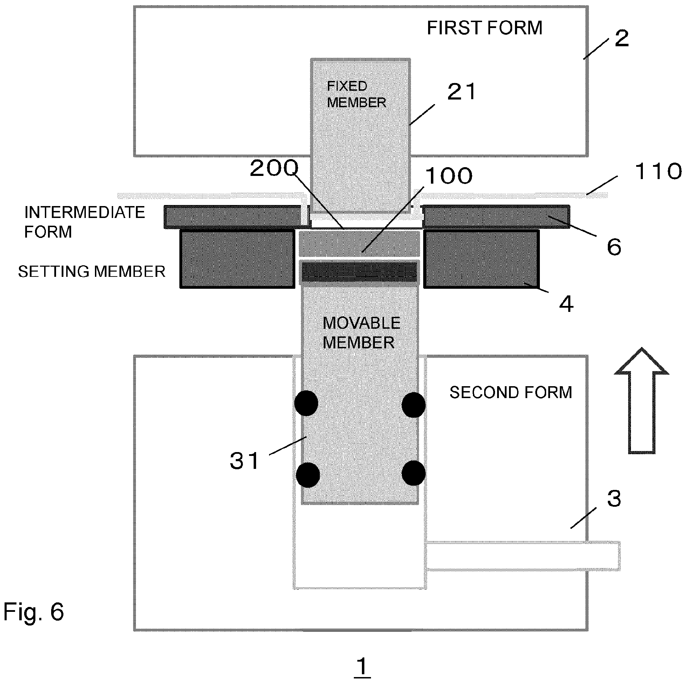

### (Approach of First Form 2 and Second Form 3: Figure 6)

Figure 6 is a block diagram of the electronic component mounting apparatus in the first embodiment of the present invention. Figure 6 depicts a state in which the first form 2 and the second form 3 approach each other. Here, by way of example, the movement control unit 5 causes the second form 3 to ascend to cause the first form 2 and the second form 3 to approach each other.

When the first form 2 and the second form 3 approach each other, a state occurs in which the fixed member 21 can make contact with the electronic component 200 via the sheet 110. With this contact state, the fixed member 21 can apply pressure to at least one of the electronic component 200 and the substrate 100.

Also, as depicted in Figure 6, the fixed member 21 enters an opening of a portion in the intermediate form 6 corresponding to the electronic component 200. This entrance allows it to enter the opening of the intermediate form 6 to apply pressure to the electronic component 200.

Also, with the contact of the fixed member 21, the sheet 110 is also pushed thereinto. By following the outer shape of the fixed member 21, the intermediate form 6, and the electronic component 200, the sheet 110 is closely attached to the surface of the electronic component 200. This sheet 110 allows the electronic component 200 to be protected from the fixed member 21.

When the movement operation by the movement control unit 5 causes the first form 2 and the second form 3 to approach each other, the state becomes such that pressure application from the fixed member 21 can be performed. Here, in Figure 6, the movement control unit 5 is connected to the second form 3 and the movement control unit 5 causes the second form 3 to ascend, but the first form 2 may be caused to descend. In either case, it is only required that the state becomes such that the first form 2 and the second form 3 approach each other.

The movement control unit 5 is only required to control an approach of the first form 2 and the second form 3 (pressure application by the fixed member 21) in accordance with sufficient strength and time for mounting the electronic component 200 on the substrate 100. These strength and time are only required to be programmed in advance to the movement control unit 5, or may be adjusted by any work. Alternatively, control may be performed with results empirically learnt.

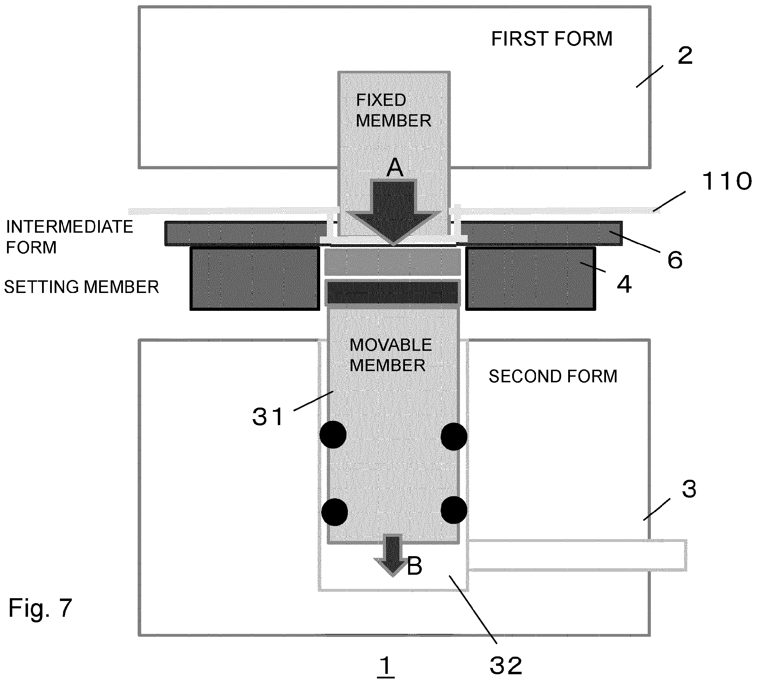

### (Pressure Application by Fixed Member 21: Figure 7)

Figure 7 is a block diagram of the electronic component mounting apparatus in the first embodiment of the present invention, depicting pressure application by the fixed member. A state in which, from the state of Figure 6, the movement control unit 5 further causes the first form 2 and the second form 3 to approach each other is depicted in Figure 7. A further approach is added to cause the fixed member 21 to become in a state of applying pressure to the electronic component 200 and the substrate 100, and the state is depicted in Figure 7.

The movement control unit 5 moves at least one of the first form 2 and the second form 3 to bring a state in which the fixed member 21 can apply pressure. Furthermore, this is kept for a predetermined time. With the state becoming as this, as indicated by an arrow A depicted in Figure 7, the fixed member 21 can apply pressure to the electronic component 200.

Here, the fixed member 21 is fixed to the first form 2. Also, the movable member 31 to receive pressure can relatively move with respect to the second form 3. As a result, overpressure, which is an excess in mounting in pressure indicated by an arrow A to be applied by the fixed member 21, is let escape so that the movable member 31 goes away from the electronic component 200.

An arrow B of Figure 7 indicates overpressure to be let escape by the movable member 31. A difference between the arrow A and the arrow B is an appropriate pressure required for mounting the electronic component 200 on the substrate 100. With this appropriate pressure, reliable mounting can be performed without damaging the electronic component 200 and the substrate 100.

Here, the second form 3 has a single or a plurality of insertion holes 32 at a position corresponding to the fixed member. The movable member 31 is inserted into this insertion hole 32. By causing the position of the movable member 31 inside the insertion hole 32 to vertically move, the movable member 31 changes the position with respect to the second form 3.

Upon receiving overpressure indicated by an arrow B in Figure 7 (when receiving pressure applied to the electronic component 200 and the substrate 100 from the fixed member 21), the movable member 31 moves inside this insertion hole 32. This movement can let overpressure escape. This is because overpressure by a positional change is let escape.

Depicted in Figure 7 is a state in which while the fixed member 21 applies pressure to the electronic component 200, overpressure is let escape by the movable member 31. As a result, reliable mounting can be achieved without applying excessive pressure to cause damages on the electronic component 200 and so forth.

Also, by adjusting the positional change amount inside the insertion hole 32, the movable member 31 can adjust overpressure to be let escape. In some cases, if overpressure to be let escape is zero, the movable member 31 does not cause a positional change with respect to the second form 3.

### (Separation of First Form and Second Form)

When mounting ends, the first form 2 and the second form 3 are separated from each other. The movement control unit 5 performs this separation. When separation is performed to remove the sheet 110 and so forth, a member in a state in which the electronic component 200 is mounted on the substrate 100 is taken out. It is rendered for use in the next process.

It is only required that the drive unit or another mechanism achieve removal of the sheet 110 and so forth. This may be a mechanism incorporated in the electronic component mounting apparatus 1 or another mechanism. These are not directly related to the present invention, and thus their description is omitted.

As described above, the electronic component mounting apparatus 1 in the first embodiment can achieve reliable mounting, while reducing risks of, for example, damaging the electronic component 200 and the substrate 100 by pressure application. Also, since optimum pressure can be applied, the thickness of the adhesive layer between the substrate 100 and the electronic component 200 can also be made as appropriate.

The vertical positional relation between the first form 2 and the second form 3 described in Figure 3 onward may be reversed. The descent and the ascent may be reversed, and the movement may not be vertical but be lateral.

### (Second Embdiment

Next, a second embodiment is described. In the second embodiment various variations and others are described.

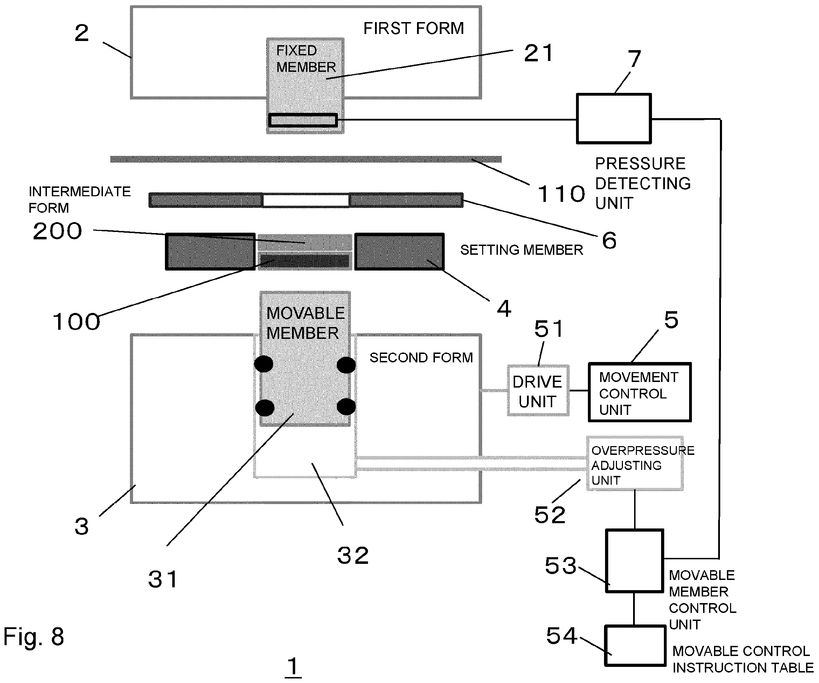

Figure 8 is a block diagram of an electronic component mounting apparatus in a second embodiment of the present invention.

The second form 3 has the movable member 31. The second form 3 is provided with the insertion hole 32, and the movable member 31 moves as being inserted inside this insertion hole 32. This movement allows a movable state. The movable member 31 moves, for example, downward, when the fixed member 21 applies pressure to the electronic component 200, thereby allowing overpressure to escape.

In the insertion hole 32, the movable member 31 is in a state in which movability is possible by air pressure, oil pressure, or the like. With respect to this air pressure or oil pressure, overpressure to be let escape can be measured. Here, as depicted in Figure 8, it is also suitable to further provide an overpressure adjusting unit 52.

The overpressure adjusting unit 52 can adjust a movement amount (movable amount, movable time, and movable speed) of the movable member 31. Overpressure to be let escape is determined by the movement amount and the way of movement of the movable member 31. The overpressure adjusting unit 52 sets overpressure to be let escape, which is set by the overpressure adjusting unit 52. In accordance with the set overpressure, the overpressure adjusting unit 52 controls the movement amount and the way of movement of the movable member 31.

With the movable member 31 moving based on this control, the movable member 31 can let necessary overpressure escape.

Here, the movable member 31 can achieve a movable state by at least one of fluid pressure, elastic pressure, and motor driving.

Also, the fixed member 21 includes a pressure detecting unit 7. The pressure detecting unit 7 detects the magnitude of pressure applied by the fixed member 21 to the electronic component 200. The pressure detecting unit 7 outputs the detected magnitude of pressure to a movable member control unit 53.

The movable member control unit 53 can read data on a movable control instruction table 54 set in advance. The movable control instruction table 54 has stored therein a relative relation between pressure to be applied by the fixed member 21 and overpressure to be let escape by the movable member 31.

Based on the pressure by the fixed member 21 notified from the pressure detecting unit 7, the movable member control unit 53 can compute overpressure to be let escape by the movable member 31. This computation result is outputted to the overpressure adjusting unit 52. The overpressure adjusting unit 52 controls movability of the movable member 31 by the overpressure based on the actual pressure by the fixed member 21 as this computation result.

In this manner, based on the value of pressure actually applied by the fixed member 21, overpressure can be let escape by the movable member 31. As a result, mounting by optimum pressure is achieved, and damages on the electronic component 200 and so forth can also be prevented.

### (Plural Mounting)

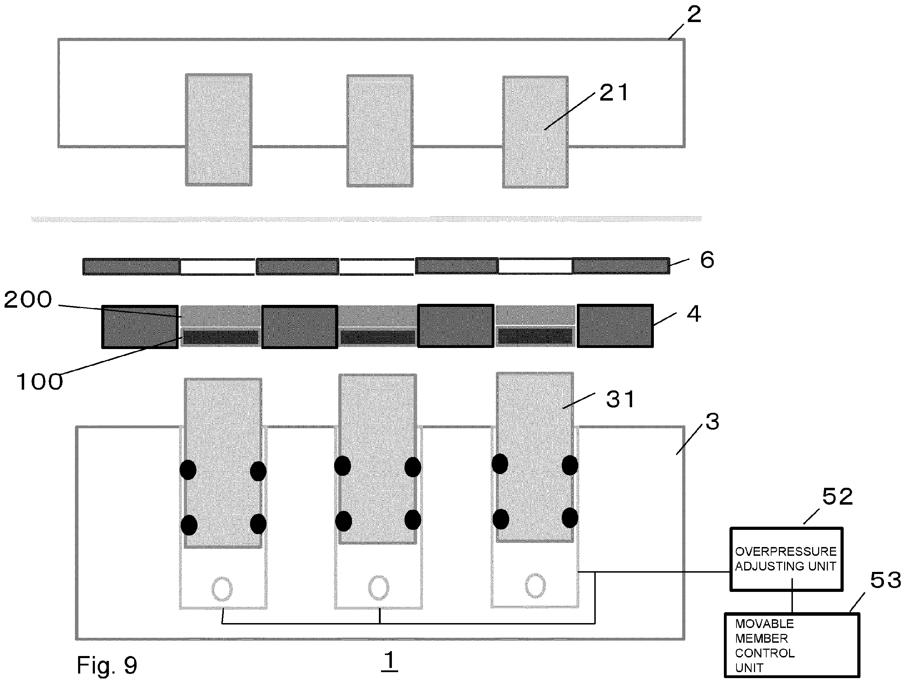

Figure 9 is a block diagram of the electronic component mounting apparatus in the second embodiment of the present invention. Figure depicts the electronic component mounting apparatus 1 which mounts the plurality of electronic components 200 all at once.

The first form 2 includes a plurality of fixed members 21. The second form 3 includes a plurality of movable members 31 at positions corresponding to these. Setting members 4 and intermediate forms 6 are also in a mode supporting this. In this manner, the electronic component mounting apparatus 1 can mount the plurality of electronic components 200 all at once.

Also in the case of Figure 9, the fixed members 21 and the movable members 31 perform operation as described above to allow mounting with optimum pressure.

Here, the plurality of electronic components 200 may have the possibility that their thickness, the amount of application of the adhesive, and so forth are varied. Mounting is preferably performed with the same pressure, irrespective of these variations in thickness and so forth.

Also, each electronic component 200 may be mounted individually with a different pressure.

Thus, each of the plurality of movable members 31 can preferably achieve a movable state individually. As depicted in Figure 9, each of the plurality of movable members 31 has its movable state controlled individually by the overpressure adjusting unit 52. With this individual control, each of the plurality of movable members 31 can achieve a movable state individually. Even if the movement amount or the gradient to be let escape is varied, each movable member 31 can operate accordingly. In addition, overpressure to be let escape can also be changed individually.

The overpressure adjusting unit 52 and the movable member control unit 53 controls at least one of the movable amount, the movable time, and the movable speed of the plurality of movable members 31 based on the value of each pressure of the plurality of fixed members 21 and the movable control instruction table. This control allows overpressure in accordance with the individual electronic components 200 to be let escape.

Alternatively, the pressure adjusting unit 52 and the movable member control unit 53 may control at least one of a movable timing and stepwise pressurization/depressurization operation. This is because controlling these also leads to control over optimum overpressure corresponding to each electronic component 200 to be let escape.

As a result, it is possible to apply optimum pressure to each electronic component 200. Even if the thickness of the electronic components 200 and the amount of application of the adhesive are varied, it is possible to prevent a problem which arises with application of optimum pressure to each electronic component 200.

As described above, the electronic component mounting apparatus 1 in the second embodiment can perform an optimum process on overpressure in accordance with the actual pressure application situation. Furthermore, the plurality of electronic components 200 can also be mounted all at once with optimum pressure.

### Reference Signs List

- 1: electronic component mounting apparatus
- 2: first form
- 21: fixed member
- 3: second form
- 31: movable member
- 32: insertion hole
- 4: setting member
- 5: movement control unit
- 6: intermediate form
- 7: pressure detecting unit
- 52: overpressure adjusting unit
- 53: movable member control unit
- 54: movable control instruction table
- 100: substrate
- 110: sheet
- 200: electronic component

## Claims

1. An electronic component mounting apparatus (1) comprising:
a first form (2) having a single or a plurality of fixed members (21);
a second form (3) having a single or a plurality of movable members (31);
a setting member (4) which is adapted to set to interpose an electronic component (200) and a substrate (100) between the first form and the second form;
a movement control unit (5) which is adapted to control an approach and separation of the first form and the second form, and
a pressure detecting unit (7) which detects pressure applied to at least one of the electronic component and the substrate, wherein
the electronic component is mounted by pressure application by the first form and the second form,
the fixed member has its position fixed with respect to the first form,
the movable member has its position changeable with respect to the second form,
the positions of the fixed member and the movable member each correspond to the electronic component to be set by the setting member,
the fixed member and the movable member are at positions opposed to each other, and
the approach by the movement control unit is adapted to allow the fixed member to apply pressure to at least one of the electronic component and the substrate, **characterized in that**
the approach by the movement control unit is adapted to allow the movable member to let overpressure, which is an excess in pressure to be applied by the fixed member, escape by movability, and
the movable member is capable of changing the movable state based on the pressure.

2. The electronic component mounting apparatus according to claim 1, wherein
the movement control unit is adapted to allow the first form and the second form to approach each other to cause the fixed member to make contact with the electronic component or the substrate, and
the contact is adapted to allow the fixed member to apply pressure to at least one of the electronic component and the substrate.

3. The electronic component mounting apparatus according to claim 1 or 2, wherein
with pressure applied by the fixed member to at least one of the electronic component and the electronic substrate and with the overpressure let escape by the movable member, the electronic component is mounted on the substrate.

4. The electronic component mounting apparatus according to any of claims 1 to 3, wherein
the fixed member is adapted to push the electronic component or the substrate to allow pressure to be applied to at least one of the electronic component and the substrate.

5. The electronic component mounting apparatus according to any of claims 1 to 4, wherein
the second form has a single or a plurality of insertion holes (32) at a position corresponding to the fixed member, and the single or the plurality of movable members are inserted into the insertion holes to become changeable in position with respect to the second form.

6. The electronic component mounting apparatus according to claim 5, wherein
the movable member is adapted to change the position in the insertion hole by pressure from the fixed member received via the electronic component and the substrate.

7. The electronic component mounting apparatus according to claim 6, wherein
the movable member is adapted to change the position inside the insertion hole to let the overpressure escape.

8. The electronic component mounting apparatus according to claim 7, wherein
the movable member is capable of adjusting an amount of the overpressure to be let escape with an amount of positional change inside the insertion hole.

9. The electronic component mounting apparatus according to any of claims 1 to 8, wherein
the fixed member, the insertion hole, and the movable member each correspond to a number of the single or the plurality of electronic components and positions thereof to be set to the setting member.

10. The electronic component mounting apparatus according to any of claims 1 to 9, wherein
a sheet (110) is set between the fixed member and the electronic component.

11. The electronic component mounting apparatus according to claim 10, further comprising an intermediate form (6) between the first form and the setting member, the intermediate form for holding an outer periphery of the electronic component, wherein
the intermediate form is capable of maintaining a state of holding the electronic component when the sheet is peeled off.

12. The electronic component mounting apparatus according to any of claims 1 to 11, wherein
the plurality of movable members are each capable of individually achieving its movable state.

13. The electronic component mounting apparatus according to any of claims 1 to 12, wherein
the plurality of movable members are each capable of achieving the movable state with at least one of fluid pressure, elastic pressure, and motor driving.

14. The electronic component mounting apparatus according to any of claims 1 to 13, further comprising a movable member control unit (53) which is adapted to control at least one of a movable amount and a movable speed of the plurality of movable members, wherein
the movable member control unit is capable of controlling at least one of the movable amount, a movable time, and the movable speed of each of the plurality of movable members based on a movable control instruction table (54) stored in advance.

## Patentansprüche

1. Eine Elektronikkomponentenmontagevorrichtung (1), umfassend:
eine erste Form (2), die ein einziges oder mehrere fixe Elemente (21) aufweist;
eine zweite Form (3), die ein einziges oder mehrere bewegliche Elemente (31) aufweist;
ein Setzelement (4), das angepasst ist, um zu setzen, dass eine elektronische Komponente (200) und ein Substrat (100) zwischen der ersten Form und der zweiten Form eingefügt werden;
eine Bewegungssteuerungseinheit (5), die angepasst ist, um eine Annäherung und eine Trennung der ersten Form und der zweiten Form zu steuern, und
eine Druckdetektionseinheit (7), die Druck detektiert, der auf die zumindest eine elektronische Komponente und das Substrat aufgebracht wird, wobei
die elektronische Komponente durch Druckaufbringung durch die erste Form und die zweite Form montiert wird,
das fixe Element seine fixe Position in Bezug auf die erste Form aufweist,
das bewegliche Element seine veränderbare Position in Bezug auf die zweite Form aufweist,
die Positionen des fixen Elements und des beweglichen Elements jeweils zu der durch das Setzelement einzusetzenden elektronischen Komponente korrespondieren,
das fixe Element und das bewegliche Element an einander gegenüberliegenden Positionen sind, und
die Annäherung durch die Bewegungssteuerungseinheit angepasst ist, um dem fixen Element zu erlauben, Druck auf die zumindest eine elektronische Komponente und das Substrat aufzubringen,
**dadurch gekennzeichnet, dass**
die Annäherung durch die Bewegungssteuerungseinheit angepasst ist, um dem beweglichen Element zu erlauben, Überdruck, der ein Überschuss des durch das fixe Element aufzubringenden Drucks ist, durch Beweglichkeit entweichen zu lassen, und
das bewegliche Element in der Lage ist, den beweglichen Zustand basierend auf dem Druck zu verändern.

2. Die Elektronikkomponentenmontagevorrichtung nach Anspruch 1, wobei die Bewegungssteuerungseinheit angepasst ist, um der ersten Form und der zweiten Form zu erlauben, sich einander anzunähern, um das fixe Element zu veranlassen, mit der elektronischen Komponente oder dem Substrat in Kontakt zu treten, und
der Kontakt angepasst ist, um dem fixen Element zu erlauben, Druck auf die zumindest eine elektronische Komponente und das Substrat aufzubringen.

3. Die Elektronikkomponentenmontagevorrichtung nach Anspruch 1 oder 2, wobei
die elektronische Komponente mit dem durch das fixe Element auf die zumindest eine elektronische Komponente und das elektronische Substrat aufgebrachten Druck und mit dem Entweichenlassen des Überdrucks durch das bewegliche Element auf dem Substrat montiert wird.

4. Die Elektronikkomponentenmontagevorrichtung nach einem der Ansprüche 1 bis 3, wobei
das fixe Element angepasst ist, um die elektronische Komponente oder das Substrat zu drücken, um es Druck zu erlauben, auf die zumindest eine elektronische Komponente und das Substrat aufgebracht zu werden.

5. Die Elektronikkomponentenmontagevorrichtung nach einem der Ansprüche 1 bis 4, wobei
die zweite Form eine einzige oder mehrere Einführungsöffnungen (32) an einer zu dem fixen Element korrespondierenden Position aufweist, und das einzige oder die mehreren beweglichen Elemente in die Einführungsöffnungen eingeführt werden, um in Bezug auf die zweite Form in der Position veränderbar zu werden.

6. Die Elektronikkomponentenmontagevorrichtung nach Anspruch 5, wobei
das bewegliche Element angepasst ist, um die Position in der Einführungsöffnung durch von dem fixen Element über die elektronische Komponente an das Substrat erhaltenen Druck zu verändern.

7. Die Elektronikkomponentenmontagevorrichtung nach Anspruch 6, wobei
das bewegliche Element angepasst ist, die Position innerhalb der Einführungsöffnung zu verändern, um Überdruck entweichen zu lassen.

8. Die Elektronikkomponentenmontagevorrichtung nach Anspruch 7, wobei
das bewegliche Element in der Lage ist, eine Menge des Überdrucks, der entweichen zu lassen ist, mit einem Betrag der Positionsveränderung innerhalb der Einführungsöffnung anzupassen.

9. Die Elektronikkomponentenmontagevorrichtung nach einem der Ansprüche 1 bis 8, wobei
das fixe Element, die Einführungsöffnung und das bewegliche Element jeweils zu einer Anzahl der einzigen oder der mehreren elektronischen Komponenten und Position davon entsprechen, die durch das Setzelement zu setzen sind.

10. Die Elektronikkomponentenmontagevorrichtung nach einem der Ansprüche 1 bis 9, wobei
eine Folie (110) zwischen das fixe Element und die elektronische Komponente gelegt ist.

11. Die Elektronikkomponentenmontagevorrichtung nach Anspruch 10, ferner umfassend eine Zwischenform (6) zwischen der ersten Form und dem Setzelement, mit der Zwischenform zum Halten eines äußeren Umfangs der elektronischen Komponente, wobei
die Zwischenform in der Lage ist, einen Zustand des Haltens der elektronischen Komponente aufrechtzuerhalten, wenn die Folie abgezogen wird.

12. Die Elektronikkomponentenmontagevorrichtung nach einem der Ansprüche 1 bis 11, wobei
die mehreren beweglichen Elemente jeweils in der Lage sind, ihren beweglichen Zustand individuell zu erreichen.

13. Die Elektronikkomponentenmontagevorrichtung nach einem der Ansprüche 1 bis 12, wobei
die mehreren beweglichen Elemente jeweils in der Lage sind, den beweglichen Zustand mit zumindest einem von einem Fluiddruck, einem elastischen Druck und einem Motorantrieb zu erreichen.

14. Die Elektronikkomponentenmontagevorrichtung nach einem der Ansprüche 1 bis 13, ferner umfassend eine Bewegungselementsteuerungseinheit (53), die angepasst ist, um zumindest eines von einem Bewegungsbetrag und einer Bewegungsgeschwindigkeit der mehreren beweglichen Elemente zu steuern, wobei
die Bewegungselementsteuerungseinheit in der Lage ist zumindest eines von einem Bewegungsbetrag, einer Bewegungsdauer und einer Bewegungsgeschwindigkeit jedes der mehreren beweglichen Elemente basierend auf einer Bewegungssteuerungsinstruktionstabelle (54), die im Voraus gespeichert ist, zu steuern.

## Revendications

1. Dispositif de montage de composant électronique (1) comprenant :
une première forme (2) comportant un seul ou une pluralité d'éléments fixes (21) ;
une seconde forme (3) comportant un seul ou une pluralité d'éléments mobiles (31) ;
un élément de positionnement (4) qui est adapté afin de positionner de manière à interposer un composant électronique (200) et un substrat (100) entre la première forme et la seconde forme ;
une unité de commande de mouvement (5) qui est adaptée afin de commander une approche et une séparation de la première forme et de la seconde forme, et
une unité de détection de pression (7) qui détecte une pression appliquée sur au moins l'un du composant électronique et du substrat, dans lequel
le composant électronique est monté par application de pression par la première forme et la seconde forme,
la position de l'élément fixe est fixée par rapport à la première forme,
la position de l'élément mobile peut être modifiée par rapport à la seconde forme,
les positions de l'élément fixe et de l'élément mobile correspondent chacune au composant électronique à positionner par l'élément de positionnement,
l'élément fixe et l'élément mobile sont à des positions opposées l'une à l'autre, et
l'approche par l'unité de commande de déplacement est adaptée afin de permettre à l'élément fixe d'appliquer une pression sur au moins l'un du composant électronique et du substrat,
**caractérisé en ce que**
l'approche par l'unité de commande de déplacement est adaptée afin de permettre à l'élément mobile de laisser une surpression, qui est un excès sur la pression à appliquer par l'élément fixe, s'échapper par mobilité, et
l'élément mobile est capable de modifier l'état de mobilité sur la base de la pression.

2. Dispositif de montage de composant électronique selon la revendication 1, dans lequel
l'unité de commande de mouvement est adaptée de manière à permettre le rapprochement de la première forme et de la seconde forme l'une de l'autre afin de provoquer le contact de l'élément fixe avec le composant électronique ou le substrat, et
le contact est adapté de manière à permettre l'application d'une pression par l'élément fixe sur au moins l'un du composant électronique et du substrat.

3. Dispositif de montage de composant électronique selon la revendication 1 ou 2, dans lequel
une pression étant appliquée par l'élément fixe sur au moins l'un du composant électronique et du substrat électronique et en laissant s'échapper la surpression par l'élément mobile, le composant électronique est monté sur le substrat.

4. Dispositif de montage de composant électronique selon l'une quelconque des revendications 1 à 3, dans lequel
l'élément fixe est adapté afin de pousser le composant électronique ou le substrat afin de permettre l'application d'une pression sur au moins l'un du composant électronique et du substrat.

5. Dispositif de montage de composant électronique selon l'une quelconque des revendications 1 à 4, dans lequel
la seconde forme présente un seul ou une pluralité d'orifices d'insertion (32) à une position correspondant à l'élément fixe, et l'élément mobile ou la pluralité d'éléments mobiles sont insérés dans les orifices d'insertion de manière à pouvoir modifier leur position par rapport à la seconde forme.

6. Dispositif de montage de composant électronique selon la revendication 5, dans lequel
l'élément mobile est adapté afin de modifier la position dans l'orifice d'insertion par une pression à partir de l'élément fixe reçue par l'intermédiaire du composant électronique et du substrat.

7. Dispositif de montage de composant électronique selon la revendication 6, dans lequel
l'élément mobile est adapté afin de modifier la position à l'intérieur de l'orifice d'insertion de manière à laisser la surpression s'échapper.

8. Dispositif de montage de composant électronique selon la revendication 7, dans lequel
l'élément mobile permet d'ajuster un niveau de la surpression à laisser s'échapper avec un niveau de changement de position à l'intérieur de l'orifice d'insertion.

9. Dispositif de montage de composant électronique selon l'une quelconque des revendications 1 à 8, dans lequel
l'élément fixe, l'orifice d'insertion et l'élément mobile correspondent chacun à un certain nombre du ou des composants électroniques et à leurs positions à définir par l'élément de positionnement.

10. Dispositif de montage de composant électronique selon l'une quelconque des revendications 1 à 9, dans lequel
une lame (110) est placée entre l'élément fixe et le composant électronique.

11. Dispositif de montage de composant électronique selon la revendication 10, comprenant, en outre, une forme intermédiaire (6) entre la première forme et l'élément de positionnement, la forme intermédiaire étant destinée à retenir une périphérie externe du composant électronique, dans lequel
la forme intermédiaire permet de maintenir un état de retenue du composant électronique lorsque la lame est retirée.

12. Dispositif de montage de composant électronique selon l'une quelconque des revendications 1 à 11, dans lequel
chaque élément mobile de la pluralité d'éléments mobiles peut assurer individuellement son état mobile.

13. Dispositif de montage de composant électronique selon l'une quelconque des revendications 1 à 12, dans lequel
les éléments mobiles de la pluralité d'éléments mobiles sont chacun capables d'assurer l'état mobile avec au moins l'un d'une pression de fluide, d'une pression élastique et d'un entraînement par moteur.

14. Dispositif de montage de composant électronique selon l'une quelconque des revendications 1 à 13, comprenant, en outre, une unité de commande d'élément mobile (53) qui est adaptée afin de commander au moins l'une d'une distance de déplacement et d'une vitesse de déplacement de la pluralité d'éléments mobiles, dans lequel
l'unité de commande d'élément mobile permet de commander au moins l'une de la distance de déplacement, d'une durée de déplacement et de la vitesse de déplacement de chacun de la pluralité d'éléments mobiles sur la base d'une table d'instruction de commande de déplacement (54) mémorisée au préalable.
